# EUROPEAN PATENT APPLICATION

(11) **EP 1 349 211 A2**
(43) Date of publication of application: **01.10.2003**
(21) Application number: 02011780.0
(22) Date of filing: 27.05.2002
(51) Int. Cl.: H01L 23/467

(54) **Rotary cooler of CPU**

(30) Priority: 27.03.2002 CN 02207992
(71) Applicant: Wang, Chin-Wen, Ping Jen City, Tao Yuan, Hsien (TW); Wang, Pei-Choa, Ping Jen City, Tao Yuan Hsien (TW); Wang, Ching Chung, Ping Jen City, Tao Yuan Hsien (TW)
(72) Inventor: Wang, Chin-Wen, Ping Jen City, Tao Yuan, Hsien (TW)
(74) Representative: Viering, Jentschura & Partner

(57) **Abstract**

The present invention relates to a rotary cooler of CPU and, more particularly, to a cooling system specially used when a CPU of a desktop computer operates. Different from the conventional open-end heat-spreading fins, the present invention provides a closed and concentrated heat-radiating structure. The rotary cooler of CPU comprises an outer ring heat spreader formed of a cylindrical ring. Heat-radiating fins radially gather together from the outer ring heat spreader to the center. A fan and heat-spreading pipes are also matched to assemble the rotary cooler of CPU. The heat-spreading pipes are extended out of a computer's housing to lead the heat source generated in the closed space of the outer ring heat spreader out of the computer's housing. The fan is used to let hot air and cold air in the heat-spreading pipes, which are extended out of the computer's housing, generate compulsory flow.

## Description

### 1. Field of the invention

The present invention relates to a rotary cooler of CPU and, more particularly, to a cooling system specially used when a central processing unit (CPU) of a desktop computer operates. The rotary cooler of CPU comprises an outer ring heat spreader formed of a cylindrical ring. Heat-radiating fins radially gather together from the outer ring heat spreader to the center. A fan and heat-spreading pipes are also matched to assemble the rotary cooler of CPU.

### 2. Background of the invention

With the operational speed of CPUs being enhanced more and more, the heat-radiating function of conventional heat-radiating fins can hardly solve the heat-radiating problem of heat source generated when the CPUs operate.

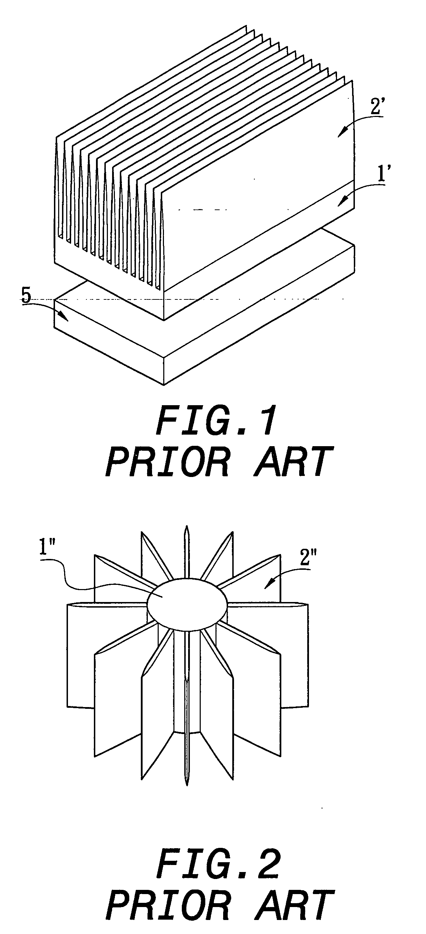

As shown in Fig. 1, in a prior art desktop computer, a plurality of erect heat-radiating fins 2' are generally used for cooling of a CPU 5 thereof. Heat source generated by the CPU 5 in the computer is spread from a bottom face 1' to the heat-radiating fins 2'.

As shown in Fig. 2, a plurality of heat-radiating fins 2" are circularly distributed with a central cylinder heat spreader 1" as the center to radiate out heat to surroundings, thereby achieving the whole heat-radiating function.

However, coolers formed of the above open-end structures of heat-radiating fins have the problem that the heat-radiating capacity thereof in limited space is much restrained. Moreover, the heat-radiating efficiency of the end face contacting the CPU is low.

Accordingly, the present invention aims to provide a rotary cooler of CPU to resolve the problems in the prior art.

### Summary of the invention

The primary object of the present invention is to provide a rotary cooler of CPU, which is a concentrated heat-radiating structure in a closed space capable of enhancing heat-radiating function. Through the special structure of the present invention, heat can be effectively and totally radiated out of the computer in circulatory way and with increased heat-radiating area, hence increasing convenience and efficiency of the present invention.

The various objects and advantages of the present invention will be more readily understood from the following detailed description when read in conjunction with the appended drawing, in which:

### Brief description of the drawings:

Fig. 1 is a perspective view of erect heat-radiating assemblies in the prior art;
Fig. 2 is a perspective view of open-end circumferential heat-radiating assemblies in the prior art;
Fig. 3 is a perspective view according to a preferred embodiment of the present invention;
Fig. 4 is a perspective view of the main body structure of the present invention;
Fig. 5 is an exploded perspective view of the main body structure of the present invention;
Fig. 6 is a front view of the main body structure of the present invention;
Fig. 7 is a front cross-sectional view of partial structure of the present invention;
Fig. 8 is a front cross-sectional view of partial structure according to another preferred embodiment of the present invention; and
Fig. 9 is a side cross-sectional view of the main body structure of the present invention.

### Detailed description of the preferred embodiments

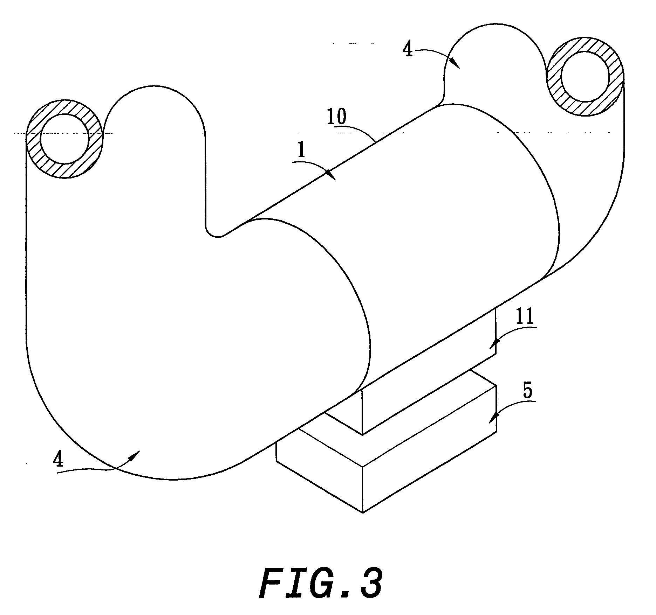

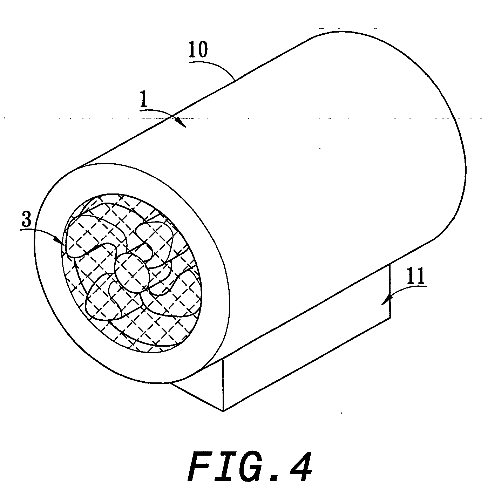

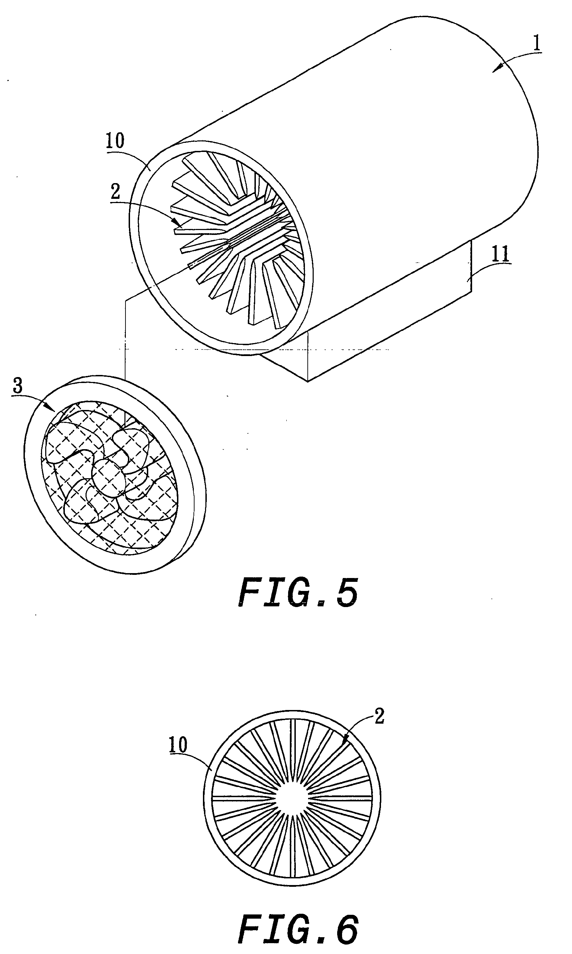

As shown in Figs. 3 to 6, the present invention provides a rotary cooler of CPU, which comprises an outer ring heat spreader 1, a plurality of heat-radiating fins 2, a fan 3, and heat-spreading pipes 4. The rotary cooler of CPU is placed on a CPU 5 to radiate out the heat generated when the CPU 5 operates.

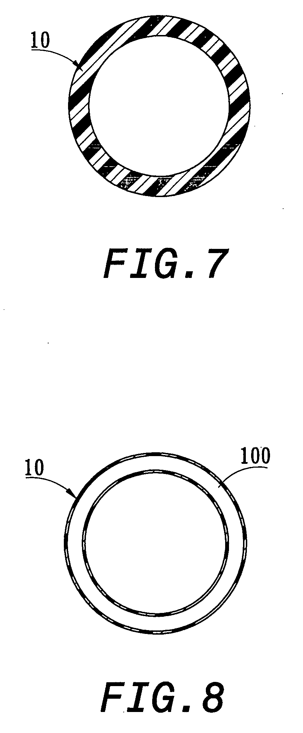

Please refer to Figs. 7 and 8. The outer ring heat spreader 1 and comprises a seat bottom face 11 and an annular wall 10. The annular wall 10 is formed of a cylindrical ring. The inner side of the annular wall 10 has a receiving space, which extends to two ends of the outer ring heat spreader 1. The seat bottom face is made of material of good conductance. The annular wall 10 enclosing the outer ring heat spreader 1 can be made of solid material (Fig. 7), and can be a hollow cavity 100 (Fig. 8). If the annular wall 10 of the outer ring heat spreader 1 is the hollow cavity 100, material of good conductance or cooling liquid can be filled therein to enhance heat-spreading function of the outer ring heat spreader 1.

The heat-radiating fins 2 are at about the central region in the outer ring heat spreader 1. The heat-radiating fins 2 project from the inner wall of the outer ring heat spreader 1, and radially gather together toward the center of the outer ring heat spreader 1.

The concentrated position of the heat-radiating fins 2 inside the outer ring heat spreader 1 is a closed space. This closed space can radiate out heat via two end spaces of the outer ring heat spreader 1 to achieve heat convection of air with the exterior.

The fan 3 is plugged in and fixedly placed at one end of the inner face of the annular wall 10 of the outer ring heat spreader 1. Airflow is generated through rotation of blades of the fan 3 to enhance the function of heat convection.

The heat-spreading pipes 4 are slipped onto two ends of the annular wall 10 of the heat spreader 1 when used. The heat-spreading pipes 4 can be extended out of a computer's housing to lead the heat source generated in the closed space of the outer ring heat spreader out of the computer's housing.

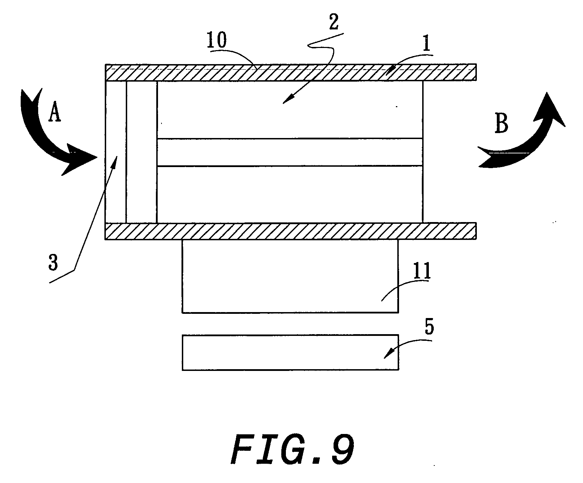

Please also refer to Fig. 9. The main heat-spreading path of the rotary cooler of CPU of the present invention is as follows. Heat source generated when the CPU 5 operates is conducted from the seat bottom face 11 of the outer ring heat spreader 1 via the annular wall 10 to the heat-radiating fins 2, which project from the inner wall 10 of the outer ring heat spreader 1, and radially gather together toward the center of the outer ring heat spreader 1. Through heat conduction of the heat-radiating fins 2, heat source is concentrated to the central cylindrical region of the outer ring spreader 1. The fan 3 is used to let hot air and cold air in the heat-spreading pipes 4 extending out of the computer's housing generate compulsory flow. Cold air enters from direction A, while hot air flows out toward direction B, hence achieving convection of cold and hot air. Heat is finally led out of the computer's housing via the heat-spreading pipes 4.

Although the present invention has been described with reference to the preferred embodiment thereof, it will be understood that the invention is not limited to the details thereof. Various substitutions and modifications have been suggested in the foregoing description, and other will occur to those of ordinary skill in the art. Therefore, all such substitutions and modifications are intended to be embraced within the scope of the invention as defined in the appended claims.

## Claims

1. A rotary cooler of CPU, especially a closed and concentrated heat-radiating structure, comprising:
an outer ring heat spreader comprising a seat bottom face made of material of good conductance and an annular wall, an inner side of said annular wall having a receiving space, which extends to two ends of said annular wall; and
a plurality of heat-radiating fins positioned at an inner side of said annular wall of the outer ring heat spreader.

2. The rotary cooler of CPU as claimed in claim 1, wherein said annular wall enclosing said outer ring heat spreader can be made of solid material.

3. The rotary cooler of CPU as claimed in claim 1, wherein said annular wall enclosing said outer ring heat spreader can be a hollow cavity.

4. The rotary cooler of CPU as claimed in claim 3, wherein said hollow cavity can be filled with material of good heat conduction or cooling liquid.

5. The rotary cooler of CPU as claimed in claim 1 further comprising heat-spreading pipes, which are slipped onto two ends of said annular wall of said outer ring heat spreader.

6. The rotary cooler of CPU as claimed in claim 1, wherein said heat-radiating fins project from the inner side of said inner wall of said outer ring heat spreader and radially gather together to a center of said outer ring heat spreader.

7. A rotary cooler of CPU, especially a closed and concentrated heat-radiating structure, comprising:
an outer ring heat spreader comprising a seat bottom face made of material of good conductance and an annular wall, an inner side of said annular wall having a hollow receiving space, which extends to two ends of said annular wall;
a plurality of heat-radiating fins positioned in at an inner side of said annular wall of the outer ring heat spreader; and
a fan plugged in and fixedly placed at one end of an inner face of said annular wall of said outer ring heat spreader.
